Europäisches Patentamt

European Patent Office

Office européen des brevets

(19)

(11) Veröffentlichungsnummer: **0 246 481**
**B1**

(12) **EUROPÄISCHE PATENTSCHRIFT**

(45) Veröffentlichungstag der Patentschrift:
27.12.90

(21) Anmeldenummer: 87106411.9

(22) Anmeldetag: 04.05.87

(51) Int. Cl.⁵: **H04N 1/028, H01L 27/14**

(54) **Kontaktbildsensorzeile.**

(30) Priorität: 13.05.86 DE 3616003

(43) Veröffentlichungstag der Anmeldung:
25.11.87 Patentblatt 87/48

(45) Bekanntmachung des Hinweises auf die Patenterteilung:
27.12.90 Patentblatt 90/52

(84) Benannte Vertragsstaaten:
BE DE FR GB IT LU NL

(56) Entgegenhaltungen:
EP-A- 0 086 907
EP-A- 0 091 798
FR-A- 2 536 551
GB-A- 2 044 996

JAPANESE JOURNAL OF APPLIED PHYSICS, Band 20, "Supplement" 20-1, 1981, Seiten 311-314, Tokyo, JP; M. MATSUMURA et al.: "A proposed novel amorphous-silicon image sensor"
PATENT ABSTRACTS OF JAPAN, Band 6, Nr. 259 (E-149)[1137], 17. Dezember 1982; & JP-A-57 157 680
XEROX DISCLOSURE JOURNAL, Band 6, Nr. 5, September-Oktober 1981, Seite 275, Stanford, Connecticut, US; J.C. STOFFEL: "A sensor array configuration using shift register"

(73) Patentinhaber: Heimann GmbH, Weher Köppel 6 Postfach 30 07, D-6200 Wiesbaden 1(DE)

(72) Erfinder: Traupe, Ulrich, Dipl.-Phys., Biebricher Allee 124, D-6200 Wiesbaden(DE)
Erfinder: Dennhoven, Manfred, Dipl.-Ing., Lahnstrasse 26, D-6200 Wiesbaden(DE)

(74) Vertreter: Fuchs, Franz-Josef, Dr.-Ing. et al, Postfach 22 13 17, D-8000 München 22(DE)

(56) Entgegenhaltungen: (Fortsetzung)
34th ELECTRONIC COMPONENTS CONFERENCE, 14.-16. Mai 1984, New Orleans, Seiten 264-268, IEEE, New York, US; M. SAKAMOTO et al.: "High speed and high resolution ISO A4 size amorphous Si:H contact linear image sensor"

## Beschreibung

Die Erfindung betrifft eine Kontaktbildsensorzeile zum Lesen einer optischen Information mit einer Reihe von lichtelektrischen Bildsensorzellen, von denen jeweils eine Anzahl auf einem Sensorzeilensegment im gleichen Abstand voneinander auf einer Geraden liegend zusammengefaßt ist, wobei eine Anzahl von Sensorzeilensegmenten die Kontaktbildsensorzeile bildet und jedes Sensorzeilensegment ein einkristallines Siliziumsubstrat umfaßt, auf dem die Bildsensorzellen vorgesehen sind und eine Ansteuer- und Signalaufbereitungsschaltung für die Bildsensorzellen als integrierte Schaltung ausgebildet ist.

Kontaktbildsensorzeilen ermöglichen das Lesen einer optischen Information, eines Textes oder einer Graphik, das Wandeln in eine analoge elektrische Information, wahlweise den Transport der analogen elektrischen Information mit anschließender elektrischer Verstärkung oder das Wandeln der analogen elektrischen Information in eine digitale elektrische Information und damit das Sortieren und Speichern der Information. Die analog aufbereitete oder die digital geordnete und gespeicherte Information kann dann in bekannter Weise für alle Formen der Bildverarbeitung und Bildwiedergabe (z.B. Fernkopieren, Bildschirmwiedergabe) nutzbar gemacht werden.

Ein Sensorzeilensegment für eine Kontaktbildsensorzeile der eingangs genannten Art ist aus "Xerox Disclosure Journal", Vol. 6, No. 5, Sept./Oct. 1981, Seite 275, bekannt. Dort sind die Bildsensorzellen durch als Photodioden wirkende Bereiche der Oberfläche des einkristallinen Siliziumsubstrates gebildet. Die Bildsensorzellen können somit nicht beliebig nahe an die Kanten des Substrates herangeführt werden, da sonst Fehlfunktionen der Bildsensorzellen, insbesondere ein zu hoher Dunkelstrom, durch Ladungsträgergeneration an der Kante des Substrates bzw. durch Ladungsträgerinjektion und Ladungsträgerdiffusion von der Kante des Substrates her verursacht würden. Während ein relativ grosser Abstand der Bildsensorzellen von derjenigen Kante des Siliziumsubstrates, die parallel zu der Geraden verläuft, auf der die Bildsensorzellen angeordnet sind, ohne Nachteile realisierbar ist, bringt ein zu großer Abstand der Begrenzungskanten der Bildsensorzellen von derjenigen Kante des Siliziumsubstrates, die quer zu der Geraden verläuft, Probleme mit sich. Beträgt nämlich der Abstand der beiden äußersten Bildsensorzellen eines Sensorzeilensegmentes von der quer zu der Geraden verlaufenden Kante des Siliziumsubstrates erheblich mehr als die Hälfte des Abstandes zwischen zwei einander benachbarten Bildsensorzellen des Sensorzeilensegmentes, ist es nicht mehr ohne weiteres möglich, mehrere Sensorzeilensegmente zu einer linearen Stoßanordnung zusammenzufassen, bei der die Bildsensorzellen aller Sensorzeilensegmente auf einer Geraden liegen, ohne daß im Bereich der Stoßkanten der Siliziumsubstrate Abbildungsfehler bzw. Bildpunktlücken infolge des dort vergrößerten Abstandes zwischen zwei benachbarten Bildsensorzellen der Kontaktbildsensorzeile auftreten. Eine Kontaktbildsensorzeile, deren Bildsensorzellen auf einer Geraden liegen und bei der zwischen sämtlichen Bildsensorzellen jeweils der gleiche Abstand eingehalten ist, könnte mittels der bekannten Sensorzeilensegmente somit nur aufgebaut werden, wenn der Abstand zwischen zwei benachbarten Bildsensorzellen eines Sensorzeilensegmentes das doppelte desjenigen Abstandes betragen würde, den die Bildsensorzellen zur Vermeidung von Fehlfunktionen von den Kanten des Siliziumsubstrates aufweisen müssen. Eine solche Kontaktbildsensorzeile würde aber infolge der dann erforderlichen großen Abstände zwischen benachbarten Bildsensorzellen eine Abbildungsqualität aufweisen, die wesentlich geringer wäre, als diejenige, die unter Berücksichtigung des kleinstmöglichen Abstandes, der bei der Ausbildung der zweier benachbarter Bildsensorzellen eines Sensorzeilensegmentes als Photodioden auf dem einkristallinen Siliziumsubstrat an sich realisierbar ist, theoretisch erreichbar ist. In der Praxis sind daher die Bildsensorzellen eines Sensorzeilensegmentes im geringstmöglichen Abstand voneinander angeordnet, wobei folglich die äußersten Bildsensorzellen eines Sensorzeilensegmentes einen demgegenüber vergrößerten Abstand von den Begrenzungskanten des Siliziumsubstrates aufweisen. Aus den bekannten Sensorzeilensegmenten bildet man deshalb eine Kontaktbildsensorzeile, indem man die Sensorzeilensegmente zick-zack-artig anordnet, das heißt, die Bildsensorzellen der einzelnen Sensorzeilensegmente liegen abwechselnd auf der einen oder der anderen zweier paralleler Geraden. Diese Geraden weisen einen Abstand auf, der größer als die Ausdehnung der Siliziumsubstrate in der Richtung quer zu der Reihe ihrer Bildsensorzellen ist. Dadurch ist es möglich, die Sensorzeilensegmente so anzuordnen, daß sie einander geringfügig überlappen und der Abstand zwischen den einander benachbarten äußersten Bildsensorzellen zweier benachbarter Sensorzeilensegmente gleich dem Abstand zwischen zwei benachbarten Bildsensorzellen eines Sensorzeilensegmentes ist.

Infolge dieser Zick-Zack-Anordnung der Sensorzeilensegmente ist zwar eine gute Abbildungsqualität erzielbar, jedoch werden gleichzeitig Informationen aus unterschiedlichen Zeilen einer abzutastenden Vorlage gelesen, so daß analoge Verschiebeschaltungen oder digitale Speicher benötigt werden, um die Informationen aus den zwei gegeneinander versetzten Zeilen zwischenzuspeichern und einander so zuzuordnen, daß die Signale einer Zeile einer Vorlage jeweils gemeinsam ausgelesen werden können.

Aufgrund der erforderlichen Datenzwischenspeicherung und Datenzuordnung erhöhen sich die Fertigungskosten der Sensorzeilen erheblich. Außerdem benötigen Lesegeräte mit versetzten Sensorzeilensegmenten einen sehr präzisen und damit teuren Papiervorschub, da bereits eine leichte Inhomogenität des Papiervorschubes zu einer Zick-Zack-Verzerrung der eingelesenen Information führt.

Aus der JP-A 57 157 680 ist eine aus Sensorzeilensegmenten aufgebaute Kontaktbildsensorzeile bekannt, bei der sämtliche Bildsensorzellen auf einer Geraden liegen. Die äußersten Bildsensorzellen der Sensorzeilensegmente weisen eine gegenüber den übrigen Bildsensorzellen verringerte Breite und vergrößerte Höhe auf, um eine gleiche Empfindlichkeit für alle Bildsensorzellen zu erzielen.

Außerdem ist aus der Literaturstelle «A Proposed Novel Amorphous-Silicon Image Sensor», M. Matsumura et al., Japanese Journal of Applied Physics, Band 20, Supplement 20–1, 1981, Seiten 311 bis 314, Tokyo, Japan, ein Bildsensor beschrieben, dessen zeilenförmig angeordnete Bildsensorzellen unter Verwendung von a-Si:H auf einem einkristallinen Siliziumsubstrat gebildet sind.

Weiter ist aus der EP-A 0 086 907 eine aus einer Anzahl von Segmenten zusammengesetzte Zeile von Lichtquellen bekannt, welche dazu dient, in einem Aufzeichnungsgerät zeilenweise Information auf einen beweglichen Lichtempfänger zu übertragen. Dabei ist vorgesehen, daß der Abstand zwischen den Zentren der einander benachbarten äußersten Lichtquellen zweier einander benachbarter Segmente nicht größer als der Abstand zwischen zwei einander benachbarten Lichtquellen eines Segmentes ist.

Es ist Aufgabe der Erfindung, eine Kontaktbildsensorzeile der eingangs genannten Art so auszubilden, daß eine Zick-Zack-Anordnung der Sensorzeilensegmente und eine damit verbundene aufwendige Signalverarbeitung vermieden sind, ohne daß im Grenzbereich zweier benachbarter Sensorzeilensegmente ein Informationsverlust auftritt und die Abbildungsqualität der Kontaktbildsensorzeile nachteilig beeinflußt wird.

Diese Aufgabe wird erfindungsgemäß dadurch gelöst, daß die Bildsensorzellen unter Verwendung von amorphem wasserstoffhaltigem Silizium (a-Si:H) gebildet sind und die einander benachbarten äußersten Bildsensorzellen der Sensorzeilensegmente jeweils bis auf ein Maß an die quer zu der Reihe der Bildsensorzellen verlaufende Begrenzungskante des jeweiligen Siliziumsubstrats heranreichen, das höchstens dem eineinhalbfachen Abstand zwischen zwei einander benachbarten Bildsensorzellen eines Sensorzeilensegmentes entspricht, und daß die Sensorzeilensegmente der Kontaktbildsensorzeile eine lineare Stoßanordnung bilden, derart, daß die Bildsensorzellen aller Sensorzeilensegmente auf einer Geraden liegen und der Abstand der voneinander abgewandten Kanten der einander benachbarten äußersten Bildsensorzellen zweier Sensorzeilensegmente der Summe der zweifachen Breite der übrigen Bildsensorzellen und des Abstandes zwischen zwei einander benachbarten Bildsensorzellen eines Sensorzeilensegmentes entspricht. Für eine gute Abbildungsqualität ist es dabei erforderlich, daß der Abstand zwischen den einander benachbarten äußersten Bildsensorzellen der Sensorzeilensegmente den vierfachen Abstand zwischen zwei einander benachbarten Bildsensorzellen eines Sensorzeilensegmentes nicht übersteigt. Eine solche Ausbildung der Kontaktbildsensorzeile ist erst dadurch möglich, daß die Bildsensorzellen unter Verwendung von a-Si:H gebildet sind. Im Gegensatz zu Bildsensorzellen, die durch als Photodioden wirkende Bereiche der Oberfläche des einkristallinen Siliziumsubstrates gebildet sind, können solche Bildsensorzellen bis unmittelbar an die Kante des Siliziumsubstrates heranreichen, ohne daß dies Fehlfunktionen infolge von Ladungsträgergeneration bzw. von Ladungsträgerinjektion und -diffusion nach sich zieht. Dies hat seinen Grund sowohl in der Verwendung unterschiedlicher Geometrien als auch in den unterschiedlichen Halbleitereigenschaften von a-Si:H gegenüber einkristallinem Silizium. Einkristalline Siliziumanordnungen werden im allgemeinen aus einem Grundmaterial mit einem spezifischen Widerstand von z. B. Rho = 10 Ohm mal cm und mit einer Dicke von einigen 100 µm hergestellt. Die Ladungsträgerdiffusionslänge beträgt einige µm. a-Si:H-Bildsensorzellen besitzen dagegen nur eine Dicke von etwa 1 µm. Der spezifische Widerstand des Bildsensorzellenmaterials beträgt z.B. Rho = $10^{11}$ Ohm mal cm und die Ladungsträgerdiffusionslänge ist kleiner als 1 µm.

Demzufolge sieht eine Variante der Erfindung vor, daß die einander benachbarten äußersten Bildsensorzellen der Sensorzeilensegmente bis unmittelbar an die Begrenzungskante des jeweiligen Siliziumsubstrates heranreichen und die Siliziumsubstrate zweier benachbarter Sensorzeilensegmente in einem Abstand voneinander angeordnet sind, der dem Abstand zwischen zwei einander benachbarten Bildsensorzellen eines Sensorzeilensegmentes entspricht. Bei einer solchen Ausbildung der Kontaktbildsensorzeile tritt im Grenzbereich zweier benachbarter Sensorzeilensegmente keinerlei Informationsverlust und keine Einbuße an Abbildungsqualität auf. Dies gilt auch für eine Kontaktbildsensorzeile, bei der die einander benachbarten äußersten Bildsensorzellen der Sensorzeilensegmente bis auf ein Maß an die Begrenzungskante des jeweiligen Siliziumsubstrates heranreichen, das höchstens dem halben Abstand zwischen zwei einander benachbarten Bildsensorzellen eines Sensorzeilensegmentes entspricht, und bei dem die Siliziumsubstrate zweier benachbarter Sensorzeilensegmente in einem solchen Abstand voneinander angeordnet sind, daß der Abstand zwischen den einander zugewandten Kanten der einander benachbarten äußersten Bildsensorzellen zweier Sensorzeilensegmente gleich dem Abstand zwischen zwei benachbarten Bildsensorzellen eines Sensorzeilensegmentes ist.

Selbst wenn die Kontaktbildsensorzeile aus fertigungstechnischen Gründen so ausgebildet ist, daß die einander benachbarten äußersten Bildsensorzellen der Sensorzeilensegmente bis auf ein Maß an die Begrenzungskante des jeweiligen Siliziumsubstrates heranreichen, das größer als der halbe Abstand zwischen zwei einander benachbärten Bildsensorzellen eines Sensorzeilensegmentes ist, und die einander benachbarten Bildsensorzellen der Sensorzeilensegmente eine gegenüber den übrigen Bildsensorzellen eines Sensorzeilensegmentes verringerte Breite aufweisen, treten noch kein Informationsverlust und keine nennenswerte Einbuße an Abbildungsqualität ein, wenn der Abstand der voneinander abgewandten Kanten der einander benachbarten äußersten Bildsensorzellen der Sensorzeilensegmente wie oben angegeben der Summe der zweifachen Breite der übrigen Bildsensorzellen und des Abstandes zwischen einander benachbarten Bildsensorzellen eines Sensorzeilensegmentes entspricht und der Abstand der äußersten Bildsensorzellen der Sensorzeilensegmente von der quer zu der Reihe der Bildsensorzellen verlaufenden Begrenzungskante des jeweiligen Siliziumsubstrates den eineinhalbfachen Abstand zwischen einander benachbarten Bildsensorzellen eines Sensorzeilensegmentes nicht übersteigt. Eine Einbuße an Abbildungsqualität kann in diesem Falle fast völlig vermieden werden, wenn die Höhe der einander benachbarten äußersten Bildsensorzellen der Sensorzeilensegmente gegenüber der der übrigen Bildsensorzellen eines Sensorzeilensegmentes derart vergrößert ist, daß sämtliche Bildsensorzellen eines Sensorzeilensegmentes die gleiche Fläche besitzen.

Im Hinblick auf einen möglichst geringen Fertigungsaufwand ist es von Vorteil, wenn nach einer Ausführungsform der Erfindung alle Sensorzeilensegmente der Kontaktbildsensorzeile gleichartig ausgebildet sind.

Bezüglich der auf dem einkristallinen Siliziumsubstrat ausgebildeten integrierten Schaltung kann vorgesehen sein, daß diese eine lineare CCD-Signalverschiebeanordnung ist und daß eine Signalaufbereitungsschaltung vorhanden ist, bei der jeder Bildsensorzelle ein individueller Verstärker nachgeschaltet ist.

Gemäß einer weiteren Variante der Erfindung ist vorgesehen, daß jedes Sensorzeilensegment zwei oder mehrere parallele Reihen aus Bildsensorzellen aufweist. Durch diese Maßnahme kann entweder eine Verdoppelung der Auslesegeschwindigkeit für das Schwarz-Weiß-Auslesen oder bei farbigem Auslesen eine Verdoppelung der Bildpunktzahl und damit der Bildauflösung gegenüber dem Lesen mit einer Reihe erzielt werden.

Die Erfindung wird nachfolgend anhand von in der Zeichnung dargestellten Ausführungsbeispielen näher erläutert. Es zeigen:

Fig. 1 eine perspektivische Darstellung einer Bildlesevorrichtung unter Verwendung einer Kontaktbildsensorzeile nach der Erfindung,

Fig. 2 eine Aufsicht auf die Kontaktbildsensorzeile gemäß Fig. 1 in schematischer Darstellung,

Fig. 3 einen vergrößerten Ausschnitt aus Figur 2,

Fig. 4 eine Darstellung analog der Fig. 3 einer Variante der Kontaktbildsensorzeile,

Fig. 5 eine Schnittdarstellung einer Bildsensorzelle der Kontaktbildsensorzeile gemäß den Fig. 1 bis 3,

Fig. 6 eine Ausführung eines Sensorzeilensegmentes,

Fig. 7 eine Variante eines Sensorzeilensegmentes, und

Fig. 8 eine Variante der Anordnung gemäß Fig. 2.

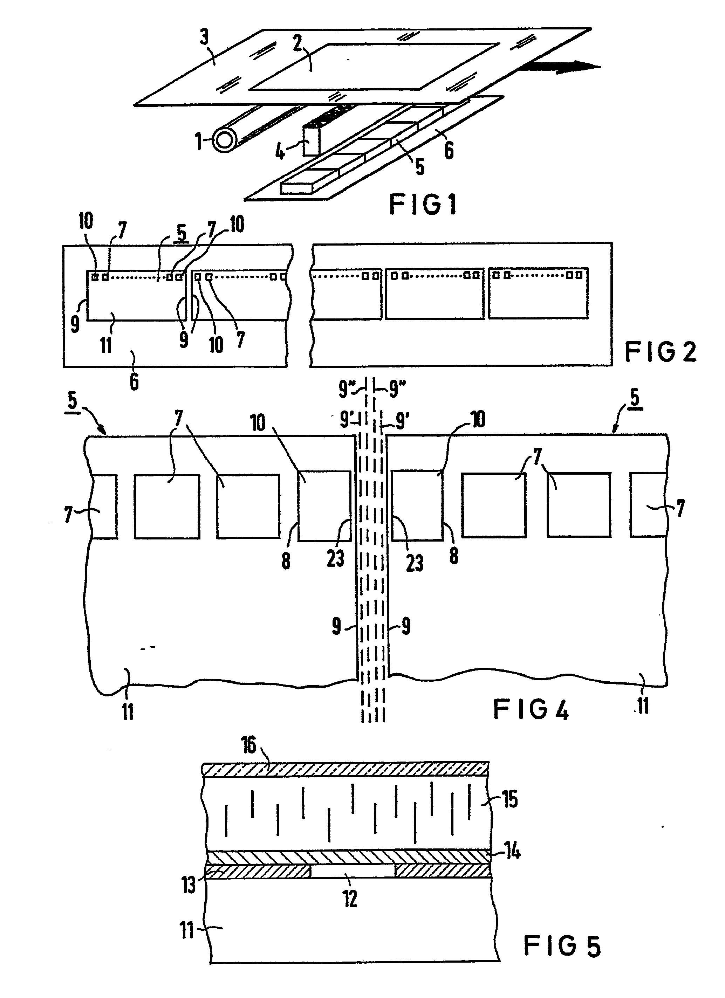

Die Fig. 1 zeigt den Aufbau einer 1:1 Bildlesevorrichtung mit einer großformatigen Kontaktbildsensorzeile, die aus einzelnen gleichartig ausgebildeten Sensorzeilensegmenten 5 gebildet ist. Eine Lichtquelle 1 beleuchtet eine Vorlage 2 auf einer Glasplatte 3. Die Information der Vorlage 2 wird über eine Grinfaseroptik 4 auf die Sensorzeilensegmente 5 abgebildet, die lichtelektrische Bildsensorzellen 7 bis 10 (siehe Fig. 2) aufweisen. Die Sensorzeilensegmente 5 befinden sich auf einem gemeinsamen Substrat 6 aus Glas oder Keramik. Das Auslesen der Information der Vorlage 2 mittels der Kontaktbildsensorzeile erfolgt in bekannter Weise durch Relativvorschub der Vorlage 2 senkrecht zur Längsachse der Kontaktbildsensorzeile.

Wie aus der Fig. 2 ersichtlich ist, sind die Sensorzeilensegmente 5 auf dem Substrat 6 in einer linearen Stoßanordnung zusammengefaßt, d.h. die Bildsensorzellen 7 bzw. 10 aller Sensorzeilensegmente 5 der Kontaktbildsensorzeile befinden sich auf einer Geraden. Auf jedem Sensorzeilensegment 5 befindet sich eine Anzahl von Bildsensorzellen 7, die jeweils im gleichen Abstand voneinander angeordnet sind. Da außerdem die von einander abgewandten Kanten 8 der einander benachbarten äußersten Bildsensorzellen zweier Sensorzeilensegmente 5 – diese Bildsensorzellen sind zur Unterscheidung von den übrigen Bildsensorzellen 7 mit der Bezugsziffer 10 versehen – der Summe der zweifachen Breite der übrigen Bildsensorzellen 7 und des Abstandes zwischen zwei einander benachbarten Bildsensorzellen 7 bzw. 10 eines Sensorzeilensegmentes 5 entspricht und die Bildsensorzellen aller Sensorzeilensegmente 5 im wesentlichen die gleichen Abmessungen aufweisen, ist die Periode des durch die Bildsensorzellen 7, 10 der Kontaktbildsensorzeile gebildeten Rasters über die gesamte Länge der Kontaktbildsensorzeile im wesentlichen konstant.

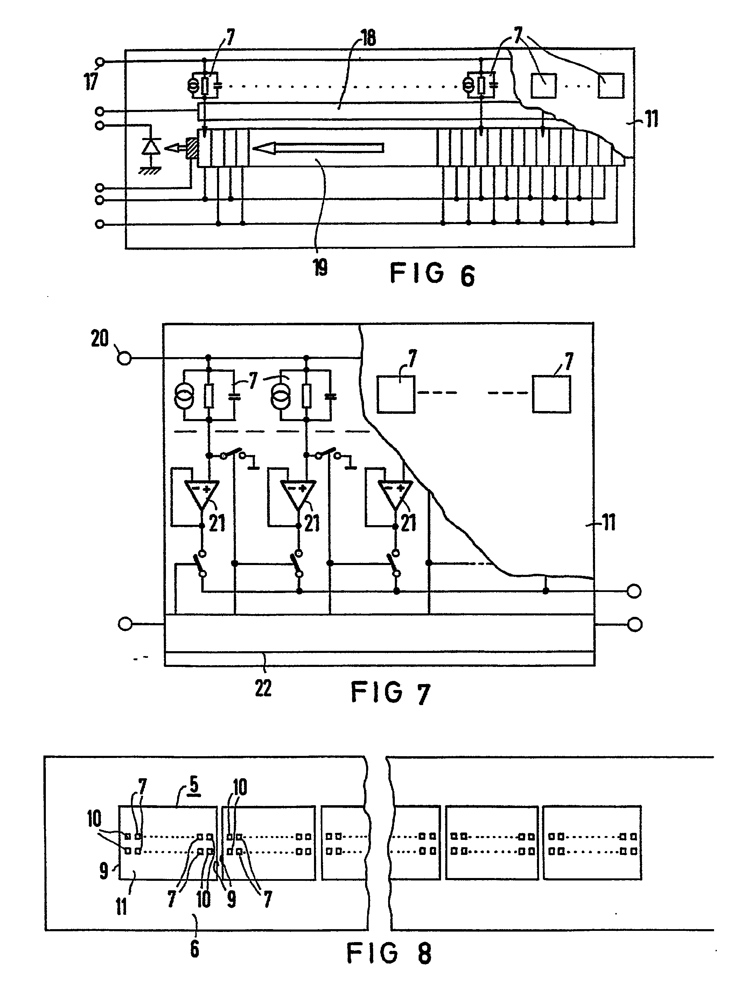

Die beschriebene Zusammenfassung der Sensorzeilensegmente 5 zu einer die Kontaktbildsensorzeile bildenden linearen Stoßanordnung wird durch den in Fig. 5 verdeutlichten Aufbau der einzelnen Sensorzeilensegmente 5 im Bereich ihrer Bildsensorzellen 7 bzw. 10 ermöglicht. Wie aus Fig. 5 anhand eines Schnittes durch eine Bildsensorzelle ersichtlich ist, befindet sich auf der Oberfläche eines einkristallinen Siliziumsubstrates 11 ein Kontakt 12, der von einer Isolatorschicht 13 umgeben ist, die die übrige Fläche des einkristallinen Siliziumsubstrates im Bereich der Bildsensorzelle abdeckt. Auf der Isolatorschicht 13 ist eine Grundelektrode 14, die z.B. aus Titan bestehen kann, vorgesehen, die mit dem Kontakt 12 in leitender Verbindung steht. Auf der Grundelektrode 14 ist die etwa 1 µm dicke a-Si:H-Fotoleiterschicht 15 vorgesehen, auf der sich eine transparente Deckelektrode 16 befindet.

Infolge der beschriebenen Ausbildung der Bildsensorzellen ist es möglich, die äußersten Bildsensorzellen 10 der Sensorzeilensegmente 5 bis unmittelbar an die in Fig. 2 mit 9 bezeichnete, quer zu der Geraden, auf der die Bildsensorzellen 7 bzw. 10 eines Sensorzeilensegmentes 5 angeordnet sind, verlaufenden Begrenzungskante des einkristallinen Siliziumsubstrates 11 heranzuführen, ohne daß Fehlfunktionen auftreten.

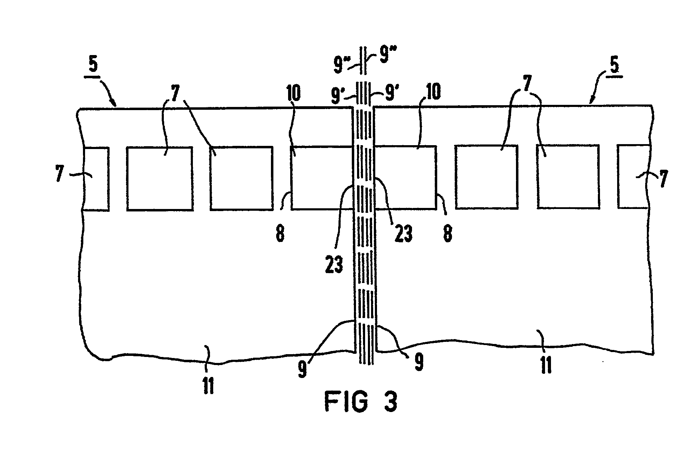

Die Kontaktbildsensorzeile kann demzufolge im Bereich der Kanten 9 der Sensorzeilensegmente 5 in der aus Fig. 3 ersichtlichen Weise ausgebildet sein. Dort weisen sämtliche Bildsensorzellen 7 bzw.

10 die gleichen Abmessungen auf. Die einander benachbarten äußersten Bildsensorzellen 10 der beiden gezeigten Sensorzeilensegmente 5 reichen bis unmittelbar an die Begrenzungskante 9 des jeweiligen Siliziumsubstrates 11 heran und die Siliziumsubstrate 11 der einander benachbarten Sensorzeilensegmente 5 sind in einem Abstand voneinander angeordnet, der dem Abstand zwischen zwei einander benachbarten Bildsensorzellen 7 bzw. 10 eines jeden der Sensorzeilensegmente 5 entspricht. Für den Fall, daß die dargestellte Kontaktbildsensorzeile zur Abtastung einer DIN A 4-Vorlage mit 12 Bildpunkten pro Millimeter (BP/mm) vorgesehen ist, weist sie eine Länge von 227,4 mm auf und besitzt 21 Sensorzeilensegmente 5 mit jeweils insgesamt 128 Bildsensorzellen 7 bzw. 10. Die Abmessungen jeder Bildsensorzelle 7, 10 betragen 70 μm in der Breite und 70 μm in der Höhe. Bei 12 BP/mm beträgt die Periode des Rasters der Bildsensorzellen 7 bzw. 10 dann 83,33 μm. Unter Berücksichtigung der angegebenen Abmessungen der Bildsensorzellen 7 bzw. 10 beträgt der Abstand zwischen zwei benachbarten Bildsensorzellen 7 bzw. 10 somit 13,33 μm. Diese Größe hat auch der Abstand zwischen den einander zugewandten Begrenzungskanten 9 der einander benachbarten Sensorzeilensegmente 5, da deren äußerste Bildsensorzellen 10 jeweils bis unmittelbar an die Begrenzungskante 9 heranreichen.

In der Praxis können die Abmessungen der Siliziumsubstrate 11 der Sensorzeilensegmente 5 nur innerhalb bestimmte Sägetoleranzen eingehalten werden. Beträgt die Sägetoleranz beispielsweise ± 2,5 μm und soll bei der in der Fig. 3 dargestellten Ausführungsform der Kontaktbildsensorzeile ausgeschlossen sein, daß die einander benachbarten äußersten Bildsensorzellen 10 der einander benachbarten Sensorzeilensegmente 5 eine geringere Breite aufweisen als die übrigen Bildsensorzellen 7 der Sensorzeilensegmente 5, muß das Nennmaß für die Lage der Begrenzungskante 9 des jeweiligen Sensorzeilensegmentes 5 so gewählt werden, daß diese bei Einhaltung des Nennmaßes einen Abstand von der zugehörigen äußersten Bildsensorzelle 10 aufweist, der der Sägetoleranz, also 2,5 μm, entspricht. Dies ist in Fig. 3 durch die strichlierte Linie 9' angedeutet. Der größtmögliche Abstand der Begrenzungskante 9 von der zugehörigen Bildsensorzelle 10 kann demzufolge 5 μm betragen und ist in Fig. 3 durch die strichlierte Linie 9'' angedeutet. Je nach Lage der Begrenzungskante 9 innerhalb des vorgegebenen Toleranzfeldes von ± 2,5 μm kann der Abstand zwischen den Begrenzungskanten 9 zweier benachbarter Sensorzeilensegmente 5 demzufolge zwischen 13,33 und 3,33 μm betragen.

In Fig. 4 ist eine Kontaktbildsensorzeile dargestellt, bei der zwischen den einander benachbarten äußersten Bildsensorzellen 10 der einander benachbarten Sensorzeilensegmente 5 ein Abstand besteht, der größer ist als der Abstand zwischen zwei einander benachbarten Bildsensorzellen 7 bzw. 10 eines jeden der Sensorzeilensegmente 5. Um die Periode des Rasters der Bildsensorzellen 7 bzw. 10 der Kontaktbildsensorzeile im wesentlichen einzuhalten, entspricht der Abstand der voneinander abgewandten Kanten 8 der einander benachbarten äußersten Bildsensorzellen 10 der Sensorzeilensegmente 5 der Summe der zweifachen Breite der übrigen Bildsensorzellen 7 und des Abstandes zwischen zwei einander benachbarten Bildsensorzellen 7 bzw. 10 eines jeden Sensorzeilensegmentes 5, wobei die einander benachbaren äußersten Bildsensorzellen 10 der Sensorzeilensegmente 5 eine gegenüber den übrigen Bildsensorzellen 7 eines jeden Sensorzeilensegmentes 5 verringerte Breite aufweisen.

Im Falle des dargestellten Ausführungsbeispieles besitzt die Kontaktbildsensorzeile 12 BP/mm. Die Abmessungen der Bildsensorzellen 7 betragen 75 μm in der Höhe und 75 μm in der Breite. Bei einer Rasterperiode von 83,33 μm beträgt der Abstand zwischen zwei Bildsensorzellen 7 bzw. 10 eines Sensorzeilensegmentes 5 somit 8,33 μm. Soll der Abstand zwischen den äußersten Bildsensorzellen 10 der Sensorzeilensegmente 5 und der Begrenzungskante 9 wenigstens 2,5 μm und der minimale Abstand zwischen den Siliziumsubstraten 11 zweier benachbarter Sensorzeilensegmente 5 ebenfalls wenigstens 2,5 μm betragen, weisen die äußersten Bildsensorzellen 10 der Sensorzeilensegmente 5 eine gegenüber deren übrigen Bildsensorzellen 7 um 4,6 μm auf 70,4 μm verringerte Breite auf. Es ist dann sichergestellt, daß die Bildsensorzellen 10 bei einer Sägetoleranz von ± 2,5 μm auch dann, wenn der Abstand zwischen den Siliziumsubstraten 11 der Sensorzeilensgmente 5 seinen Maximalwert von 12,5 μm (Minimalabstand 2,5 μm plus 2 mal Sägetoleranz 5 μm) aufweist, jeweils 2,5 μm vor der Kante 9 des Siliziumsubstrates enden. In der Fig. 4 sind die Begrenzungskanten 9 in ihrem minimalen Abstand von den Bildsensorzellen 10 dargestellt. Außerdem sind in strichlierter Darstellung die mit 9' bezeichnete Nennlage und die mit 9'' bezeichnete jeweils am weitesten von den Bildsensorzellen 10 entfernte Lage der Begrenzungskanten 9 der Siliziumsubstrate 11 eingetragen.

Wie aus der Fig. 4 ersichtlich ist, weisen die äußersten Bildsensorzellen 10 der Sensorzeilensegmente 5 eine gegenüber den übrigen Bildsensorzellen 7 vergrößerte Höhe auf, und zwar ist die Höhe der Bildsensorzellen 10 unter Berücksichtigung von deren geringerer Breite derart vergrößert, daß die Bildsensorzellen 7 und 10 die gleiche Fläche aufweisen. Bei einer um 4,6 μm verringerten Breite der Bildsensorzellen 10 ist dazu eine Vergrößerung von deren Höhe um 4,9 μm erforderlich, wobei die Bildsensorzellen 10 derart angeordnet sind, daß sie die Bildsensorzellen 7 in beiden Richtungen jeweils um 2,45 μm überragen. Infolge dieses symmetrischen Höhenversatzes tritt im ungünstigsten Anwendungsfall, dem Lesen eines Schwarz-Weiß-Sprunges parallel zu der Geraden, auf der die Bildsensorzellen 7 bzw. 10 angeordnet sind, eine Grauabweichung von weniger als 3% auf. Bei einer Wiedergabe von zum Beispiel 16 Graustufen ist eine solche Abweichung nicht wahrnehmbar.

Um im Bereich der äußersten Bildsensorzellen 10 der Sensorzeilensegmente 5 eine Einbuße an Abbildungsqualität zu vermeiden, ist es erforderlich, daß das Maß, bis auf das die Bildsensorzellen 10 an die Kante 9 des jeweiligen Siliziumsubstrates 11 heranreichen, den eineinhalbfachen Abstand zwischen einander benachbarten Bildsensorzellen 7 bzw. 10 eines Sensorzeilensegmentes 5 nicht übersteigt. Gleichzeitig darf der Abstand zwischen den einander zugewandten Kanten 23 der einander benachbarten äußersten Bildsensorzellen 10 zweier Sensorzeilensegmente 5 den vierfachen Abstand zwischen einander benachbarten Bildsensorzellen 7 bzw. 10 eines Sensorzeilensegmentes 5 nicht übersteigen.

Die Fig. 6 zeigt eine Ausführungsform eines Sensorzeilensegmentes 5, bei der sich die a-Si:H-Bildsensorzellen 7 auf einem einkristallinen Siliziumsubstrat 11 befinden, das eine CCD-Zeilenschaltung 19 enthält. Die a-Si:H-Bildsensorzellen 7 sind gemäß Figur 4 aufgebaut. Die Kontaktierung der gemeinsamen transparenten Deckelelektrode erfolgt über den Kontakt 17. Das Auslesen der Bildsensorzellen erfolgt in üblicher Weise über ein Transfergatter 18. Der Ladungstransport in der CCD-Zeilenschaltung 19 und das Auslesen erfolgen ebenfalls in üblicher Weise wie in dem hier als Beispiel dargestellten 2-Phasen CCD.

Die Fig. 7 zeigt eine andere Ausführungsform gemäß eines Sensorzeilensgmentes 5, bei der sich die a-Si:H-Bildsensorzellen 7 mit einem Aufbau gemäß Figur 4 auf einem einkristallinen Siliziumsubstrat 11 befinden, das eine Einzelbildpunktverstärkerschaltungsanordnung enthält. Die Kontaktierung der gemeinsamen transparenten Deckelelektrode erfolgt über den Anschluß 20. Die Verstärkung der Bildpunktsignale erfolgt in den zugeordneten Verstärkern 21. Die Steuerung des Transportes der verstärkten Signale zum Ausgang erfolgt in bekannter Weise durch digitale Schieberegister 22.

Statt einer Reihe von Bildsensorzellen pro Sensorzeilensegment 5 können z.B. auch zwei Reihen pro Sensorzeilensegment 5 gemäß Fig. 8 angeordnet werden. Die Anordnung von zwei Reihen in der Mitte der Sensorzeilensegmente 5 ermöglicht entweder eine Verdoppelung der Auslesegeschwindigkeit für das Schwarz-Weiß-Auslesen oder bei farbigem Auslesen eine Verdoppelung der Bildpunktzahl und damit Bildauflösung gegenüber dem Lesevorgang mit einer Reihe.

Es sind auch Anordnungen mit drei oder mehreren Reihen möglich. Die Anordnung mit zwei Reihen ist aus Symmetriegründen jedoch sowohl für Kontaktbildsensorzeilen mit CCD-Anordnung als auch für Kontaktbildsensorzeilen mit Einzelbildpunktverstärkeranordnung besonders vorteilhaft.

In den Figuren 6 und 7 sind der Einfachheit halber die jeweils randnächsten Bildsensorzellen wie die übrigen Bildsensorzellen 7 gezeichnet. Auch hier ist eine Variation der Breite und Höhe entsprechend Fig. 4 möglich.

**Patentansprüche**

1. Kontaktbildsensorzeile zum Lesen einer optischen Information mit einer Reihe von lichtelektrischen Bildsensorzellen (7, 10), von denen jeweils eine Anzahl auf einem Sensorzeilensegment (5) im gleichen Abstand voneinander auf einer Geraden liegend zusammengefaßt ist, wobei eine Anzahl von Sensorzeilensegmenten (5) die Kontaktbildsensorzeile bildet und jedes Sensorzeilensegment (5) ein einkristallines Siliziumsubstrat (11) umfaßt, auf dem die Bildsensorzellen (7, 10) vorgesehen sind und eine Ansteuer- und Signalaufbereitungsschaltung für die Bildsensorzellen (7, 10) als integrierte Schaltung ausgebildet ist, dadurch gekennzeichnet, daß die Bildsensorzellen (7, 10) unter Verwendung von amorphem wasserstoffhaltigem Silizium (a-Si:H) gebildet sind und die einander benachbarten äußersten Bildsensorzellen (10) der Sensorzeilensegmente (5) jeweils bis auf ein Maß an die quer zu der Reihe der Bildsensorzellen (7, 10) verlaufende Begrenzungskante (9) des jeweiligen Siliziumsubstrates (11) heranreichen, das höchstens dem eineinhalbfachen Abstand zwischen zwei einander benachbarten Bildsensorzellen (7, 10) eines Sensorzeilensegmentes (5) entspricht, und daß die Sensorzeilensegmente (5) der Kontaktbildsensorzeile eine lineare Stoßanordnung bilden, derart, daß die Bildsensorzellen (7, 10) aller Sensorzeilensegmente (5) auf einer Geraden liegen und der Abstand der von einander abgewandten Kanten (8) der einander benachbarten äußersten Bildsensorzellen (10) zweier Sensorzeilensegmente (5) der Summe der zweifachen Breite der übrigen Bildsensorzellen (7) und des Abstandes zwischen zwei einander benachbarten Bildsensorzellen (7, 10) eines Sensorzeilensegmentes (5) entspricht.

2. Kontaktbildsensorzeile nach Anspruch 1, dadurch gekennzeichnet, daß die einander benachbarten äußersten Bildsensorzellen (10) der Sensorzeilensegmente (5) bis unmittelbar an die Begrenzungskante (9) des jeweiligen Siliziumsubstrates (11) heranreichen und die Siliziumsubstrate (11) zweier benachbarter Sensorzeilensegmente (5) in einem Abstand von einander angeordnet sind, der dem Abstand zwischen zwei einander benachbarten Bildsensorzellen (7, 10) eines Sensorzeilensegmentes (5) entspricht.

3. Kontaktbildsensorzeile nach Anspruch 1, dadurch gekennzeichnet, daß die einander benachbarten äußersten Bildsensorzellen (10) der Sensorzeilensegmente (5) bis auf ein Maß an die Begrenzungskante (9) des jeweiligen Siliziumsubstrates (11) heranreichen, das höchstens dem halben Abstand zwischen zwei einander benachbarten Bildsensorzellen (7, 10) eines Sensorzeilensegmentes (5) entspricht, und die Siliziumsubstrate (11) zweier benachbarter Sensorzeilensegmente (5) in einem solchen Abstand voneinander angeordnet sind, daß der Abstand zwischen den einander zugewandten Kanten (23) der einander benachbarten äußersten Bildsensorzellen (10) zweier Sensorzeilensegmente (5) gleich dem Abstand zwischen zwei benachbarten Bildsensorzellen (7, 10) eines Sensorzeilensegmentes (5) ist.

4. Kontaktbildsensorzeile nach Anspruch 1, bei der die einander benachbarten äußersten Bildsensorzellen (10) der Sensorzeilensegmente (5) bis auf ein Maß an die Begrenzungskante (9) des jeweiligen Siliziumsubstrates (11) heranreichen, das größer als der Abstand zwischen zwei einander benachbarten Bildsensorzellen (7, 10) eines Sensorzeilensegmentes (5) ist, dadurch gekennzeichnet, daß die einander benachbarten äußersten Bildsensorzellen (10) der Sensorzeilensegmente (5) eine gegenüber den übrigen Bildsensorzellen (7) eines Sensorzeilensegmentes (5) verringerte Breite aufweisen.

5. Kontaktbildsensorzeile nach Anspruch 4, dadurch gekennzeichnet, daß die Höhe der einander benachbarten äußersten Bildsensorzellen (10) der Sensorzeilensegmente (5) gegenüber der der übrigen Bildsensorzellen (7) eines Sensorzeilensegmentes (5) derart vergrößert ist, daß sämtliche Bildsensorzellen (7, 10) eines Sensorzeilensegmentes (5) die gleiche Fläche besitzen.

6. Kontaktbildsensorzeile nach einem der Ansprüche 1 bis 5, dadurch gekennzeichnet, daß alle Sensorzeilensegmente (5) der Kontaktbildsensorzeile gleichartig ausgebildet sind.

7. Kontaktbildsensorzeile nach einem der Ansprüche 1 bis 6, dadurch gekennzeichnet, daß als integrierte Schaltung eine lineare CCD-Signalverschiebeanordnung gewählt ist (Fig. 5).

8. Kontaktbildsensorzeile nach einem der Ansprüche 1 bis 6, dadurch gekennzeichnet, daß als integrierte Schaltung eine Signalaufbereitungsschaltung vorhanden ist, bei der jeder Bildsensorzelle (7, 10) ein individueller Verstärker (21) nachgeschaltet ist (Fig. 6).

9. Kontaktbildsensorzeile nach einem der Ansprüche 1 bis 8, dadurch gekennzeichnet, daß jedes Sensorzeilensegment (5) zwei oder mehrere parallele Reihen aus Bildsensorzellen (7, 10) aufweist.

Claims

1. A contact image sensor array for reading optical data with a row of photoelectric image sensor cells (7, 10), a number of which are in each case combined on a sensor array segment (5), at the same distance from each other, lying in a straight line, wherein a number of sensor array segments (5) forms the contact image sensor array and each sensor array segment (5) includes a mono-crystalline silicon substrate (11), on which the image sensor cells (7, 10) are provided and a control and signal processing circuit for the image sensor cells (7, 10) designed as an integrated circuit, characterised in that the image sensor cells (7, 10) are formed using amorphous hydrogen-containing silicon (a-Si:H) and the outermost image sensor cells (10), adjacent to each other, of the sensor array segments (5) each reach up to a distance short of the boundary edge (9) of the respective silicon substrate (11) extending transverse to the row of image sensor cells (7, 10), which distance corresponds at the most to one and a half times the distance between two image sensor cells (7, 10) of one sensor array segment (5) and in that the sensor array segments (5) of the contact image sensor array form a linear abutment arrangement such that the image sensor cells (7, 10) of all sensor array segements (5) lie in a straight line and the distance from the edges (8), facing away from each other, of the outermost image sensor cells (10), adjacent to each other, of two sensor array segments (5) corresponds to the sum of two times the width of the remaining image sensor cells (7) and the distance between two adjacent image sensor cells (7, 10) of a sensor array segment (5).

2. A contact image sensor array according to claim 1, characterised in that the outermost image sensor cells (10), adjacent to each other, of the sensor array segments (5) reach directly to the boundary edge (9) of the respective silicon substrate (11) and the silicon substrates (11) of two adjacent sensor array segments (5) are arranged at a distance from each other, which corresponds to the distance between two adjacent image sensor cells (7, 10) of a sensor array segment (5).

3. A contact image sensor array according to claim 1, characterised in that the outermost image sensor celles (10), adjacent to each other, of the sensor array segments (5) reach up to a distance short of the boundary edge (9) of the respective silicon substrate (11), which corresponds at the most to half the distance between two adjacent image sensor cells (7, 10) of a sensor array segement (5), and the silicon substrates (11) of two adjacent sensor array segments (5) are arranged at such a distance from each other, that the distance between the edges (23), facing each other, of the outer image sensor cells (10), adjacent to each other, of two sensor array segments (5) is equal to the distance between two adjacent image sensor cells (7, 10) of a sensor array segment (5).

4. A contact image sensor array according to claim 1 in which the outermost image sensor cells (10), adjacent to each other, of the sensor array segments (5) reach up to a distance short of the boundary edge (9) of the respective silicon substrate (11), which is greater than the distance between two adjacent image sensor cells (7, 10) of a sensor array segment (5), characterised in that the outermost image sensor cells (10), adjacent to each other, of the sensor array segements (5) have, relative to the remaining image sensor cells (7) of a sensor array segment (5), a reduced width.

5. A contact image sensor array according to claim 4, characterised in that the height of the outermost image sensor cells (10), adjacent to each other of the sensor array segments (5), relative to the remaining image sensor cells (7) of a sensor array segment (5), are enlarged such that all images sensor cells (7, 10) of a sensor array segment (5) have the same area.

6. A contact image sensor array according to one of claims 1 to 5, characterised in that all sensor array segments (5) of the contact image sensor array are constructed in the same manner.

7. A contact image sensor array according to one of claims 1 to 6, characterised in that a linear CCD signal shift arrangement is selected as an integrated circuit (Figure 5).

8. A contact image sensor array according to one of claims 1 to 6, characterised in that a signal processing circuit is present as integrated circuit, in which an individual amplifier (21) is connected downstream of each image sensor array (7, 10)(Figure 6).

9. A contact image sensor array according to one of claims 1 to 8, characterised in that each sensor array segment (5) has two or several parallel rows of image sensor cells (7, 10).

**Revendications**

1. Ligne de détecteurs d'images à contact pour la lecture d'une information optique, comportant une série de cellules photoélectriques (7, 10) des détecteurs d'images, dont un certain nombre est rassemblé sur un segment (5) de la ligne de détecteurs en étant équidistant sur une droite, un certain nombre de segments de ligne de détecteurs (5) formant la ligne de détecteurs d'images à contact et chaque segment (5) de la ligne de détecteurs comprenant un substrat en silicium monocristallin (11), sur lequel les cellules (7, 10) des détecteurs d'images sont prévues et sur lequel un circuit de commande et de préparation de signaux pour les cellules (7, 10) des détecteurs d'images est réalisé sous la forme d'un circuit intégré, caractérisée par le fait que les cellules (7, 10) des détecteurs d'images sont formées moyennant l'utilisation de silicium hydrogéné amorphe (a-Si:H) et que les cellules les plus extérieures (10) voisines les unes des autres des détecteurs d'images des segments (5) de la ligne de détecteurs, s'étendent respectivement jusqu'à un certain niveau en-deçà du bord limite (9) du substrat en silicium respectifs (11), qui s'étend transversalement à la série des cellules (7, 10) de détecteurs d'images, et qui correspond au maximum à une fois et demie à la distance présente entre deux cellules voisines (7, 10) de détecteurs d'images d'un segment (5) de la ligne de détecteurs, et que les segments (5) de la ligne de détecteurs d'images à contact forment une chaîne linéaire d'éléments mis bout à bout de sorte que les cellules (7, 10) des détecteurs d'images de tous les segments (5) de la ligne de détecteurs sont situées sur une droite et que la distance entre les bords (8) situés à l'opposé les uns des autres, des cellules les plus extérieures (10), voisines les unes des autres, des lignes (7) de détecteurs d'images correspond à la somme du double de la largeur des autres cellules (7) des détecteurs d'images et de la distance entre deux cellules (7, 10), voisines l'une de l'autre, des détecteurs d'images d'un segment (5) de la ligne de détecteurs.

2. Ligne de détecteurs d'images à contact suivant la revendication 1, caractérisée par le fait que les cellules les plus extérieures (10), voisines les unes des autres, des détecteurs d'images des segments (5) de la ligne de détecteurs s'étendent jusqu'à proximité immédiate du bord limite (9) du substrat en silicium respectif (11) et que les substrats en silicium (11) de segments voisins (5) de lignes de détecteurs sont disposés à une distance mutuelle correspondant à la distance entre deux cellules mutuellement voisines (7, 10) de détecteurs d'images d'un segment (5) d'une ligne de détecteurs.

3. Ligne de détecteurs d'images à contact suivant la revendication 1, caractérisée par le fait que les cellules les plus extérieures (10), mutuellement voisines des détecteurs d'images des segments (5) de la ligne de détecteurs s'étendent à une certaine distance en-deçà du bord limite (9) du substrat en silicium respectif (11), qui correspond au maximum à la moitié de la distance entre deux cellules réciproquement voisines (7, 10) de détecteurs d'images d'un segment (5) de la ligne de détecteurs, et que les substrats en silicium (11) de deux segments voisins (5) de la ligne de détecteurs sont disposés à une distance mutuelle telle que la distance entre les bords (23) situés mutuellement à l'opposé l'un de l'autre des cellules les plus extérieures (10), mutuellement voisines, des détecteurs d'images de deux segments (5) de la ligne de détecteurs est égale à la distance entre deux cellules mutuellement voisines (7, 10) de détecteurs d'images d'un segment (5) de la ligne de détecteurs.

4. Lignes de détecteurs d'images à contact suivant la revendication 1, dans laquelle les cellules les plus extérieures respectivement voisines (10) de détecteurs d'images des segments (5) de la ligne de détecteurs s'étendent jusqu'à une certaine distance en-deçà du bord limite (9) du substrat en silicium respectif (11) qui est supérieure à la distance entre deux cellules mutuellement voisines (7, 10) de détecteurs d'images d'un segment (5) de la ligne de détecteurs, caractérisée par le fait que les cellules les plus extérieures respectivement voisines (10) des détecteurs d'images des segments (5) de la ligne de détecteurs possèdent une largeur réduite par rapport aux autres cellules (7) de détecteurs d'images d'un segment (5) de la ligne de détecteurs.

5. Ligne de détecteurs d'images de contact suivant la revendication 4, caractérisée par le fait que la hauteur des cellules les plus extérieures voisines l'une de l'autre (10) des détecteurs d'image des segments (5) de la ligne de détecteurs est accrue par rapport à la hauteur des autres cellules (7) des détecteurs d'images d'un segment (5) de la ligne de détecteurs de sorte que toutes les cellules (7, 10) des détecteurs d'images d'un segment (5) de la ligne de détecteurs possèdent la même surface.

6. Ligne de détecteurs d'images de contact suivant l'une des revendications 1 à 5, caractérisée par le fait que les segments (5) de la ligne de détecteurs d'images à contact sont identiques.

7. Ligne de détecteurs d'images à contact suivant l'une des revendications 1 à 6, caractérisée par le fait qu'on choisit, comme circuit intégré, un dispositif linéaire à décalage de signaux CCD (figure 5).

8. Ligne de détecteurs d'images à contact suivant l'une des revendications 1 à 6, caractérisée par le fait qu'il est prévu, comme circuit intégré, un circuit de préparation de signaux, dans lequel l'amplificateur individuel (21) est branché en aval de chaque cellule (7, 10) de détecteurs d'images (figure 6).

9. Ligne de détecteurs d'images à contact suivant l'une des revendications 1 à 8, caractérisée par le fait que chaque segment (5) de la ligne de détecteurs possède deux ou plusieurs rangées parallèles de cellules (7, 10) de détecteurs d'images.

FIG 1

FIG 2

FIG 4

FIG 5

FIG 3

FIG 6

FIG 7

FIG 8